Europäisches Patentamt

European Patent Office

Office européen des brevets

(19)

(11) Veröffentlichungsnummer: **0 163 302**
**B1**

(12) **EUROPÄISCHE PATENTSCHRIFT**

(45) Veröffentlichungstag der Patentschrift :
28.03.90

(21) Anmeldenummer : 85106625.8

(22) Anmeldetag : 29.05.85

(51) Int. Cl.$^5$ : **H 03 K 4/64**

(54) Ansteuerschaltung für einen Ablenk-Leistungstransistor.

(30) Priorität : 30.05.84 DE 3420312

(43) Veröffentlichungstag der Anmeldung :
04.12.85 Patentblatt 85/49

(45) Bekanntmachung des Hinweises auf die Patenterteilung : 28.03.90 Patentblatt 90/13

(84) Benannte Vertragsstaaten :
FR GB IT NL SE

(56) Entgegenhaltungen :
EP–A– 0 045 882
EP–A– 0 159 233
DE–A– 3 043 354
IBM TECHNICAL DISCLOSURE BULLETIN, Band 17, Nr. 4, September 1974, Seiten 1091-1092, Yorktown Heights, US; K.H. KNICKMEYER: "Dynamic transistor antisaturation control"
ELECTRONIC APPLICATIONS, Band 34, Nr. 2, Oktober 1976, Seiten 52-60, Eindhoven, NL; D. Arentsen et al.: "The effect of base–current waveform"

(73) Patentinhaber : SGS-THOMSON MICROELECTRONICS GMBH
Bretonischer Ring 4
D-8011 Grasbrunn b. München (DE)

(72) Erfinder : Melbert, Joachim G., Dr.
Flurweg 8
D-8019 Steinhöring (DE)
Erfinder : Sawicki, Eduard
Wotanstrasse 37
D-8000 München 19 (DE)

(74) Vertreter : Klunker . Schmitt-Nilson . Hirsch
Winzererstrasse 106
D-8000 München 40 (DE)

Jouve, 18, rue St-Denis, 75001 Paris, France

## Beschreibung

Die Erfindung betrifft eine Ansteuerschaltung für einen Leistungstransistor, der sich in einer Ablenkschaltung eines Fernsehgeräts befindet und eine Ablenkwicklung mit einem rampenförmig ansteigenden Ablenkstrom versorgt, wobei die Ansteuerschaltung periodisch mit Einschaltimpulsen einer der Rampenlänge des Ablenkstroms entsprechenden Dauer gespeist wird, den Leistungstransistor während der Einschaltimpulsdauer mit einem ansteigenden Einschaltbasisstrom beaufschlagt, der den Leistungstransistor während im wesentlichen der gesamten Einschaltimpulsdauer in den Sättigungszustand steuert, und nach Beendigung des Einschaltimpulses den Leistungstransistor mit einem im Verhältnis zum Anstieg des Einschaltbasisstroms rasch abnehmenden und schließlich die Polarität wechselnden Abschaltbasisstrom steuert, der eine schnelle Rückführung des Leistungstransistors aus dem Sättigungs- in den Sperrzustand bewirkt.

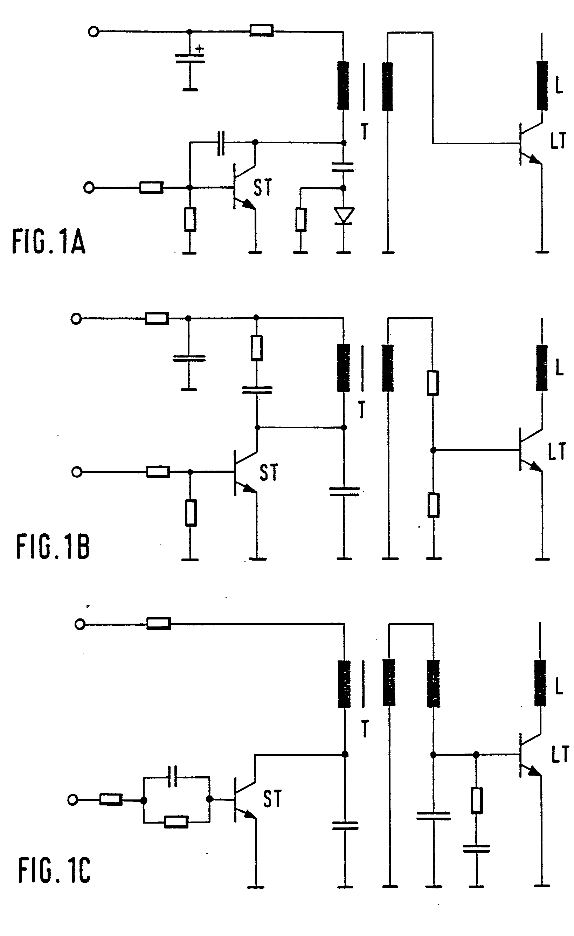

Diese Ansteuerschaltung ist hauptsächlich für den Einsatz in der Horizontalablenkstufe von Fernsehgeräten und Videomonitoren gedacht. Herkömmliche Schaltungen zur Ansteuerung des Leistungstransistors in der Horizontalablenkstufe sind durch diskrete Bauelemente realisiert. Drei charakteristische Beispiele für solche herkömmliche Schaltungen sind in Fig. 1 gezeigt. Alle drei Schaltungen weisen einen Leistungstransistor LT auf, dessen Kollektor eine Ablenkwicklung L speist und dessen Basiskreis über einen Transformator T an eine Treiberschaltung angeschlossen ist. Die Treiberschaltung weist jeweils einen Steuertransistor ST auf, dessen Basis zeilenfrequente Einschaltimpulse zuführbar sind, die den Steuertransistor ST jeweils in den leitenden Zustand bringen.

Auf der Kollektorseite des Leistungstransistors LT befindet sich eine komplexe Schaltung, die bei konstanter Spannung über der Ablenkwicklung L einen mit konstanter Steilheit ansteigenden Strom hervorruft, solange der Leistungstransistor LT leitend geschaltet ist und einen entsprechend hohen Strom liefern kann. Damit die Bedingung einer konstanten Spannung über der Ablenkwicklung L aufrechterhalten werden kann, wird dafür gesorgt, daß die Emitter-Kollektor-Strecke des Leistungstransistors LT während der Einschaltzeit einen konstanten Spannungsabfall aufweist. Dies erreicht man dadurch, daß man den Leistungstransistor LT während seiner Einschaltzeit in den Sättigungszustand steuert. Dafür bedarf es zu jedem Zeitpunkt der Einschaltdauer des Einschaltimpulses eines Mindestbasisstroms des Leistungstransistors.

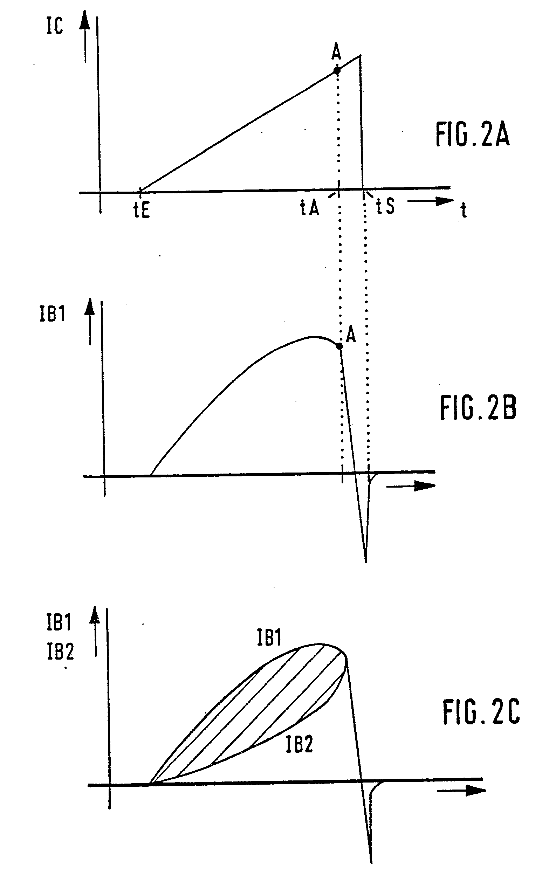

Die Fig. 2a und 2b zeigen den rampenförmig ansteigenden Kollektorstrom IC bzw. den Verlauf des Basisstroms IB1, mit dem der Leistungstransistor angesteuert wird. Die beiden Stromverläufe sind durch die konstanten passiven Komponenten des den Leistungstransistor umgebenden Schaltungsnetzwerks festgelegt.

Da der Leistungstransistor während seiner Einschaltdauer in den Sättigungsbereich übersteuert wird, ist seine Abschaltung nur mit einer Abschaltverzögerung möglich, innerhalb welcher die Basis des übersteuerten Transistors entladen wird. Daher dauert der rampenförmige Anstieg des Kollektorstroms IC nicht nur vom Einschaltzeitpunkt tE bis zum Ausschaltzeitpunkt tA des dem Steuertransistor ST zugeführten Einschaltimpulses, sondern geht der Kollektorstrom erst nach Ablauf einer die Abschaltverzögerung bewirkenden Speicherzeit tS auf Null zurück. Die Länge der Speicherzeit hängt von der Steilheit das Basisabschaltstroms im Bereich zwischen den Zeitpunkten tA und tS ab. Da während dieses Abschaltvorgangs Kollektorstrom und Kollektorspannung des Leistungstransistors gleichzeitig endliche Werte haben, können während dieses Abschaltvorgangs erhebliche Verlustleistungen bis in den Bereich von einigen undert Watt auftreten, die für die Verluste im Leistungstransistor in besonderer Weise bestimmend sind. Um einerseits die Zeitdauer, während welcher solche hohen Verlustleistungen auftreten, zu verringern und außerdem den Leistungstransistor rechtzeitig für das nächste Ablenkintervall bereitzuhaben, macht man die Abfallflanke des Abschaltbasisstroms möglichst steil. Dem sind aber dadurch Grenzen gesetzt, daß es bei einer zu steilen Abfallflanke des Abschaltbasisstroms zu einer inhomogenen Basisentladung kommt, die zu dem sogenannten « emitter crowding » führt, einem unerwünschten Effekt. Dazwischen liegt eine optimale Abfallflanke, die durch Dimensionierung des den Leistungstransistor umgebenden Netzwerks festgelegt wird.

Die Stromverstärkung des Leistungstransistors ist eine nichtlineare Funktion des Kollektorstroms, die zu größeren Kollektorstromwerten hin relativ stark abnimmt. Da der durch das Schaltungsnetzwerk festgelegte Verlauf des Basisstroms IB1 im Einschaltbereich zwischen tE und tA einen Verlauf mit monoton abnehmender Steigung aufweist, ist der Übersteuerungsgrad des Leistungstransistors kleiner, wenn der Kollektorstrom IC im Abschaltzeitpunkt tA einen größeren Wert hat, und ist der Übersteuerungsgrad größer, wenn der Kollektorstrom im Abschaltzeitpunkt einen kleineren Wert hat. Da die Abfallflanke des Basisstroms durch das den Leistungstransistor umgebende Netzwerk festgelegt ist, ergibt sich bei größeren Endwerten des Kollektorstroms eine kleinere Speicherzeit und bei kleineren Endwerten des Kollektorstroms eine größere Speicherzeit.

Der Horizontalablenkstufe ist eine Signalverarbeitungsschaltung zugeordnet, welche die Ablenkfrequenz und die Bildlage, d. h., die Phasenlage des Ablenksignals, bestimmt. Hierzu gehört ein im allgemeinen als $\phi$2-Regler bezeichneter Regelkreis, der die Phasenlage zwischen dem Zeilenrücklaufsignal und dem Horizontalgenerator steuert. Das Zeilenrücklaufsignal entsteht, wenn der Leistungstransistor hochohmig wird, d. h., wenn der Kollektorstrom IC am Ende der Speicherzeit tS auf Null zurückgeht.

In Abstimmung auf das Verhalten des den Leistungstransistor umgebenden Netzwerks ist dieser Regelkreis darauf eingerichtet, daß die Entladezeit oder Speicherzeit umgekehrt proportional zum Endwert des Kollektorstroms ist.

Die bekannten Ansteuerschaltungen, deren typischste Beispiele in Fig. 1 gezeigt sind, sind jeweils für eine bestimmte Ablenkfrequenz und für einen bestimmten Ablenkendstrom ausgelegt. Wird eine andere Ablenkfrequenz benötigt, z. B. für einen Videomonitor mit höherer Auflösung, oder benötigt man unterschiedliche Endwerte des Ablenkstroms und damit des Kollektorstroms IC, beispielsweise für unterschiedliche Bildschirmgrößen und/oder für Bildröhren mit unterschiedlichem maximalem Ablenkwinkel, muß man die bekannten Ansteuerschaltungen anders auslegen. Das bedeutet, daß man für die vielen verschiedenen Fernsehgeräte- und Monitortypen entsprechend viele Ansteuerschaltungen bereitstellen muß und die Ansteuerschaltung bei geänderten Anforderungen neu auslegen muß.

Der Erfindung liegt die Aufgabe zugrunde, die eingangs angegebene Ansteuerschaltung derart zu verbessern, daß sie bei voller Kompatibilität mit dem bekannten φ2-Regler für beliebige Ablenkfrequenzen und beliebige maximale Ablenkströme verwendbar ist.

Die Lösung besteht bei der eingangs angegebenen Ansteuerschaltung darin, daß dem Leistungstransistor eine Sensorvorrichtung zugeordnet ist, die der Ansteuerschaltung ein dem Momentanwert des Transistorhauptstroms proportionales Istwertsignal liefert, daß die Ansteuerschaltung den Einschaltbasisstrom während seines gesamten Anstiegs in Abhängigkeit von dem Istwertsignal auf einen Wert regelt, der den Leistungstransistor mit nur geringer Übersteuerung im gesättigten Zustand hält, und daß die Ansteuerschaltung die Steilheit des Abschaltbasisstroms proportional zu dem am Ende des Einschaltimpulses auftretenden Istwertsignal steuert.

Aufgrund der Regelung des Basisstroms des Leistungstransistors in Abhängigkeit von dem Istwert seines Kollektorstroms paßt sich die erfindungsgemäße Ansteuerschaltung selbsttätig an unterschiedliche Bedingungen hinsichtlich der Ablenkfrequenz und des maximalen Ablenkstroms an. Da es mit dieser Ansteuerschaltung möglich ist, den Leistungstransistor während seiner gesamten Einschaltdauer immer nur eben im übersteuerten Bereich zu halten, kann die Speicherzeit sehr kurz gemacht werden, was bei einer Erhöhung der Zeilenzahl zum Erhalt einer besseren Auflösung spezieller Videomonitore im Hinblick auf die dann erforderliche hohe Ablenkfrequenz besonders wichtig sein kann. Dadurch, daß man die Abfallflanke des Abschaltbasisstroms proportional zum Endwert des Kollektorstroms des Leistungstransistors steuert, bildet man das Verhalten der bekannten Ansteuerschaltungen nach, deren Basisentladezeit oder Speicherzeit umgekehrt proportional zum Endwert des Kollektorstroms ist. Die erfindungsgemäße Ansteuerschaltung ist daher vollständig kompatibel mit dem bekannten φ2-Regler, so daß dieser unverändert mit der erfindungsgemäßen Ansteuerschaltung zusammenarbeiten kann.

Die erfindungsgemäße Schaltung kommt ohne den herkömmlicherweise in der Horizontalablenkstufe verwendeten Transformator aus. Damit fällt ein relativ teures und anfälliges Bauelement weg. Außerdem ist die erfindungsgemäße Ansteuerschaltung dadurch ohne Probleme monolithisch integrierbar. Es tritt der weitere Vorteil auf, daß der Leistungstransistor gleichspannungsmäßig ansteuerbar ist, während bei den herkömmlichen Lösungen wegen des Transformators nur eine Wechselspannungsansteuerung in Frage kommt. Die Möglichkeit der beliebigen Gleichspannungsansteuerung erlaubt das Abgreifen beliebiger Gleichspannungszwischenwerte vom Leistungstransistor, so daß dieser ohne Probleme als Gleichspannungsquelle beispielsweise im sogenannten Stand-by-Betrieb, in dem das Fernsehgerät nur teilausgeschaltet ist, gehalten werden kann.

Sensorvorrichtungen einzusetzen, um bei Transistoren sättigungsbedingte Abschaltverzögerungszeiten zu reduzieren, ist bereits im IBM TECHNICAL DISCLOSURE BULLETIN, Band 17, Nr. 4, September 1974, Seiten 1091, 1092 und in der nachveröffentlichten älteren EP-A-0 159 233 beschrieben, und zwar im Fall der ersten Druckschrift allgemein und im Fall der zweiten Druckschrift im Zusammenhang mit einer Ablenkschaltung. In beiden Fällen wird die Abschaltverzögerung dadurch reduziert, daß die Basis des Transistors mit Hilfe der Sensorvorrichtung derart angesteuert wird, daß der Transistor außerhalb der Sättigung gehalten wird.

Ablenkschaltungen, bei denen wie im Fall der Schaltungen gemäß den beiliegenden Figuren 1A bis 1C der Basisstromverlauf nicht in Abhängigkeit von dem mit einer Sensorvorrichtung gemessenen Transistorhauptstrom gesteuert sondern durch im Basiskreis befindliche Schaltungskomponenten vorgegeben wird, sind aus der DE-A-3 043 354, aus ELECTRONIC APPLICATIONS, Band 34, Nr. 2, Oktober 1976, Seiten 52-60, und aus der EP-A-0 045 882 bekannt. Bei den beiden erstgenannten Druckschriften wird entweder ein rampenförmig ansteigender oder über den größten Teil der Einschaltdauer konstant gehaltener Basisstrom durch ein bestimmtes Schaltungsnetzwerk erzeugt. Im Fall der letztgenannten Druckschrift wird der Basisstromverlauf mit Hilfe von Impulsen generiert, die von einem programmierten Digitalspeicher stammen und zu dem gewünschten Basisstromverlauf geglättet werden. Dabei kommt es entweder zu einer tiefen Sättigung mit einhergehender Ausschaltzeitverzögerung oder — im Fall des rampenförmig ansteigenden Basisstroms — es wird ein Basisstromverlauf erzeugt, von den man hofft, daß er an keiner Stelle zu einer Sättigung des Transistors führt.

Bei einer besonders bevorzugten Ausführungsform der Erfindung ist die Sensorvorrichtung durch einen im Emitterkreis des Leistungstransistors liegenden Emitterwiderstand gebildet, über den eine Istwertspannung abgreifbar ist, die zum Kollektorstrom des Leistungstransistors proportional ist. In weiterhin besonders bevorzugter Weise weist die Ansteuerschaltung eine Transkonduktanzstufe auf, der über einen Istwerteingang die am Emitterwiderstand des Leistungstransistors abgegriffene Istwertspannung zuführbar ist, und die außerdem einen Steuerausgang aufweist, der mit der Basis des Leistungstransistors verbunden ist. Die Transkonduktanzkennlinie dieser Transkonduktanzstufe bestimmt, ein wie großer Basisstrom dem Leistungstransistor bei der jeweils gemeldeten Istwertspannung zugeführt wird. Oder anders ausgedrückt, die Form der Transkonduktanzkennlinie bestimmt, welcher Basisstrom bei dem jeweils gemessenen Kollektorstrom an den Leistungstransistor geliefert wird. Über die Transkonduktanzkennlinie kann man also bestimmen, in wie starke Sättigung der Leistungstransistor beim jeweils fließenden Kollektorstrom gebracht wird.

Das hinsichtlich der Verringerung der Leistungsverluste und der Speicherzeit günstigste Ergebnis erhält man, wenn man die Transkonduktanzstufe mit einer nichtlinearen Transkonduktanzkennlinie ausrüstet, deren Verlauf eine inverse Nachbildung des Kennlinienverlaufs der Stromverstärkung des Leistungstransistors in Abhängigkeit von dessen Kollektorstrom ist. Eine derartige Transkonduktanzkennlinie in der Ansteuerschaltung führt zu einem Basisstromverlauf, wie er in Fig. 2c mit IB2 bezeichnet ist. Durch diesen β-inversen Basisstromverlauf wird berücksichtigt, daß die Stromverstärkung β mit zunehmendem Kollektorstrom in nichtlinearer Weise abnimmt. Um den Leistungstransistor während des gesamten rampenförmigen Anstiegs seines Kollektorstroms IC immer nur gerade eben in der Sättigung zu halten, wird angesichts dieses abfallenden β-Verlaufs der Basisstrom IB2 in der dargestellten Weise immer stärker erhöht. Man kommt bei dieser β-inversen Steuerung des Basisstroms IB2 zu einer Verringerung der Leistungsverluste entsprechend der schraffierten Fläche in Fig. 2c.

In der Praxis reicht es aus, den β-inversen Verlauf von IB2 angenähert nachzubilden. Für erfindungsgemäße Ansteuerschaltungen, bei denen man den Schaltungsaufwand möglichst gering halten möchte, verwendet man vorzugsweise eine lineare Transkonduktanzkennlinie, mit der ein linearer Anstieg des Basisstroms des Leistungstransistors gesteuert wird. Damit erreicht man immer noch eine bemerkenswerte Verringerung der Leistungsverluste und auch eine erhebliche Verringerung der Speicher- bzw. Basisentladezeit, da der Leistungstransistor insbesondere bei geringeren Werten des Kollektorendstroms viel weniger stark übersteuert ist als bei Verwendung der herkömmlichen Ansteuerschaltungen, die zum Basisstromverlauf IB1 führen.

Eine lineare Transkonduktanzkennlinie ist außerdem von Vorteil, wenn man zur Invarianz der erfindungsgemäßen Ansteuerschaltung gegenüber der jeweils verwendeten Ablenkfrequenz und gegenüber dem im speziellen Fall erforderlichen Endwert des Kollektorstroms eine zusätzliche Unabhängigkeit von dem Transistortyp, d. h., von seiner speziellen β-Kennlinie, erreichen möchte.

In besonders bevorzugter Weise wird die Transkonduktanzstufe mit einer spannungsgesteuerten Stromquelle verwirklicht.

Bevorzugtermaßen ist die Transkonduktanzstufe in Abhängigkeit davon, ob gerade ein Einschaltimpuls vorhanden ist oder nicht, in zwei unterschiedliche Zustände steuerbar. Während des Vorhandenseins eines Einschaltimpulses gelangt sie in einen ersten Zustand, in dem sie zur Steuerung des ansteigenden Basiseinschaltstroms nur auf die ihr zugeführte Istwertspannung reagiert. In dem zweiten Zustand, den sie bei Beendigung des Einschaltimpulses einnimmt, reagiert sie zur Steuerung des abfallenden Basisausschaltstroms auf das Verhältnis zwischen der Istwertspannung und einer rasch ansteigenden Steuerspannung, die sich auf den Basisstrom entgegengesetzt wie die Istwertspannung auswirkt. Dabei ist die Steilheit der im zweiten Zustand wirkenden Steuerspannung proportional zur Istwertspannung veränderbar. Mit einer derartigen Transkonduktanzstufe kann im zweiten Zustand die Abfallflanke des Basisausschaltstroms in Abhängigkeit von dem Endwert, den der Kollektorstrom bei Beendigung des Einschaltimpulses erreicht hat, gesteuert werden, und zwar derart, daß die Abfallflanke um so steiler ist, je höher der vom Kollektorstrom erreichte Endwert ist. Auf diese Weise wird der Vorgang des Entladens der übersteuerten Basis des Leistungstransistors in einer Zeitdauer beendet, die umgekehrt proportional zu dem vom Kollektorstrom erreichten Endwert ist, wie dies auch bei den bekannten Ansteuerschaltungen der Fall ist. Durch diese Maßnahme ist sichergestellt, daß sich die erfindungsgemäße Ansteuerschaltung hinsichtlich der Abhängigkeit der Ausschaltverzögerung vom Endwert, den der Kollektorstrom erreicht, genauso wie die herkömmlichen Ansteuerschaltungen verhält und daher mit dem für diese herkömmlichen Ansteuerschaltungen konzipierten φ2-Regler kompatibel ist.

Bei einer besonders bevorzugten Ausführungsform der erfindungsgemäßen Ansteuerschaltung weist die Transkonduktanzstufe einen Differenzverstärker und eine dessen Ausgang nachgeschaltete Spannung-Strom-Wandlerstufe, deren Ausgang den Steuerausgang der Transkonduktanzstufe bildet, auf. Dabei ist der eine der beiden Eingänge des Differenzverstärkers mit dem Istwerteingang der Ansteuerschaltung verbunden, während der andere Eingang des Differenzverstärkers an eine Parallelschaltung aus einem Kondensator und der Hauptstrecke eines Überbrückungstransistors angeschlossen ist. Dabei ist die Parallelschaltung einen Endes an ein Bezugspotential, vorzugsweise Masse, und anderen Endes an eine Stromquelle, deren Stromstärke proportional zur Istwertspannung steuerbar ist, angeschlossen. Die Steuerelektrode des Überbrückungstransistors ist an den Einschaltimpulseingang der Ansteuerschaltung angeschlossen und der Überbrückungstransistor ist durch den Einschaltimpuls leitend schaltbar und sperrt ansonsten. Bei dieser Ausführungsform wird während des Anliegens eines Einschaltimpulses über den leitend geschalteten Überbrückungstransistor das Potential am einen Eingang des Differenzverstärkers auf dem Bezugspotential festgehalten, so daß die Ausgangsspannung des Differenzverstärkers und somit der vom Ausgang der Transkonduktanzstufe abgegebene Einschaltbasisstrom nur von der rampenförmig ansteigenden Istwertspannung in ansteigender Weise beeinflußt wird.

Am Ende des jeweiligen Einschaltimpulses wird dann der Überbrückungstransistor in den Sperrzustand geschaltet, so daß der von der steuerbaren Stromquelle gelieferte und in seinem Wert von der Istwertspannung abhängende Strom den Kondensator aufladen kann. Die Ausgangsspannung des Differenzverstärkers und damit der von der Transkonduktanzstufe abgegebene Basisstrom für den Leistungstransistor werden nun von dem Verhältnis zwischen der Istwertspannung auf der einen Seite des Differenzverstärkers und der Kondensatoraufladespannung auf der anderen Seite des Differenzverstärkers bestimmt. Da die Aufladespannung des Kondensators rasch ansteigt, nähert sie sich der Istwertspannung vom Emitterwiderstand des Leistungstransistors immer mehr, bis sie diese Istwertspannung schließlich einholt und daran anschließend überholt. Als Folge davon fällt der der Basis des Leistungstransistors zugeführte Basisausschaltstrom rasch ab, wobei er beim Erreichen des Nullwerts seine Polarität wechselt, von da ab die übersteuerte Basis entlädt und dann, wenn die Basis gänzlich entladen ist, auf Null zurückgeht. Da die Anstiegsgeschwindigkeit der Kondensatoraufladespannung proportional zu dem vom Kollektorstrom des Leistungstransistors erreichten Endwert ist, ist auf diese Weise erreicht, daß auch die Steilheit des Abfalls des Ausschaltbasisstroms proportional zu diesem Endwert des Kollektorstroms ist.

Die Erfindung und Weiterbildungen der Erfindung werden nun anhand einer Ausführungsform näher erläutert. In der Zeichnung zeigen :

Fig. 1 drei herkömmliche Ansteuerschaltungen für den Leistungstransistor in der Horizontalablenkstufe eines Fernsehempfängers ;

Fig. 2 zeitliche Stromverläufe im Leistungstransistor ;

Fig. 3 ein Prinzip-Blockschaltbild einer bevorzugten Ausführungsform der erfindungsgemäßen Ansteuerschaltung, und zwar für eine Horizontalablenkschaltung.

Fig. 4 die Schaltungsstruktur einer besonders bevorzugten Ausführungsform der erfindungsgemäßen Ansteuerschaltung.

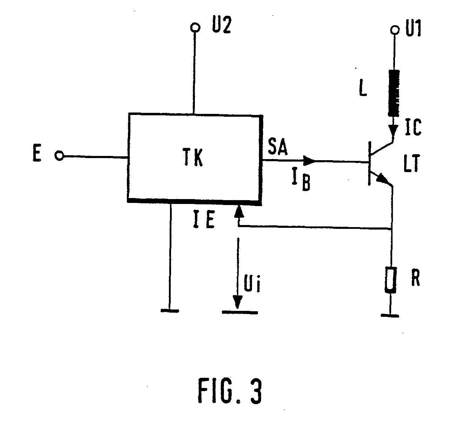

Die Prinzipdarstellung in Fig. 3 zeigt einen Leistungstransistor LT, dessen Kollektor-Emitter-Strecke wie bei den bekannten Ansteuerschaltungen in Reihe zur Horizontalablenkwicklung L geschaltet ist. Die Horizontalablenkwicklung L ist an dem nicht mit LT verbundenen Ende an eine Spannungsquelle U1 angeschlossen, die, solange LT im Sättigungszustand ist, einen rampenförmig ansteigenden Kollektorstrom IC bewirkt, wie er in Fig. 2a gezeigt ist. Zwischen den Emitter von LT und Masse ist ein Sensorwiderstand R geschaltet, über dem eine Istwertspannung $U_i$ abnehmbar ist, die dem Kollektorstrom IC proportional ist. Die Basis von LT ist an den Steuerausgang SA einer Transkonduktanzstufe TK angeschlossen, der über einen Istwerteingang IE die über dem Sensorwiderstand R abgegriffene Istwertspannung $U_i$ zugeführt wird und der über einen weiteren Eingang E zeilenfrequente Einschaltimpulse zugeführt werden. Die Transkonduktanzstufe TK ist außerdem zwischen eine sie speisende Spannungsquelle U2 und Masse geschaltet.

Die Transkonduktanzstufe TK stellt eine spannungsgesteuerte Stromquelle mit dem Übertragungsverhalten oder der Transkonduktanz

$$g = IB/U_i$$

dar. Die Kennlinie der Transkonduktanz g kann bei einfacherer Schaltungsauslegung linear gemacht werden oder bei höherem Schaltungsaufwand nichtlinear, um den stark gekrümmten Verlauf der Stromverstärkung β des Leistungstransistors als Funktion von dessen Kollektorstrom zu berücksichtigen. Dabei kann der Transkonduktanzverlauf β-invers gemacht werden, mindestens in Annäherung. In diesem Fall wird die Transkonduktanz g der Transkonduktanzstufe TK so festgelegt, daß sich der Leistungstransistor LT bei jedem Wert des rampenförmig ansteigenden Kollektorstroms IC gerade in der Sättigung befindet. Es gilt daher

$$IB = C\frac{IC}{\beta_{min}(IC)},\qquad(1)$$

und

$$IB = g(U_i)\,R\,IC\qquad(2)$$

Dabei ist C der Übersteuerungsfaktor und $\beta_{min}(IC)$ die Stromverstärkung des Leistungstransistors LT als Funktion seines Kollektorstroms IC. Der Index min kennzeichnet den Minimalwert der Stromverstärkung des für den Leistungstransistor verwendeten Transistortyps in Abhängigkeit von dessen Exemplarstreuung. Es folgt damit für die Transkonduktanz der Treiberschaltung :

$$g = \frac{I_B}{U_i}\qquad(3)$$

und

$$g = \frac{C}{\beta_{min}(IC)\,R}\qquad(4)$$

Die Zeitabhängigkeit des mitgekoppelten Regelkreises ist ausschließlich durch die Lastimpedanz des Leistungstransistors LT festgelegt und resultiert aus der Reaktanz des Ablenksystems und des Zeilentransformators. Die Ansteuerschaltung paßt sich somit selbsttätig an unterschiedliche Betriebsbedingungen an.

Bei Verwendung eines β-inversen Transkonduktanzverlaufs erhält man den in Fig. 2c gezeigten Basiseinschaltstrom IB2. Die in Fig. 2c schraffierte Fläche entspricht der Reduzierung der Ansteuerleistung gegenüber der herkömmlichen Ansteuermethode, die zu dem Einschaltbasisstrom IB1 führt.

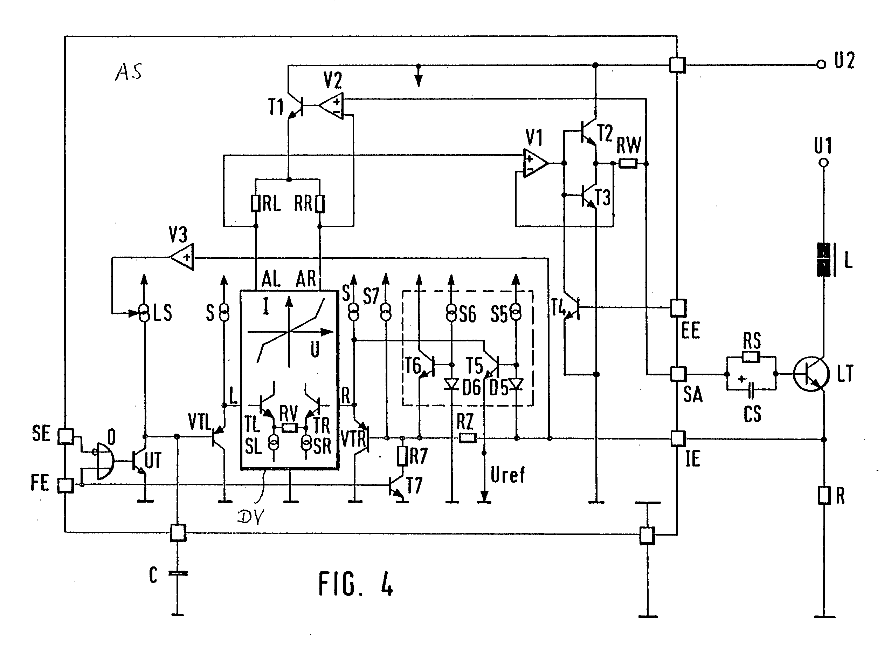

Eine ausführlichere Blockstruktur einer bevorzugten Ausführungsform der erfindungsgemäßen Ansteuerschaltung, einschließlich einem Schaltungsteil, das diese Ansteuerschaltung mit dem herkömmlichen ɸ2-Regler kompatibel macht, ist in Fig. 4 gezeigt. Der Leistungstransistor LT ist kollektorseitig über die Horizontalablenkwicklung L mit einer Ablenkspannungsquelle U1 und emitterseitig über den Sensorwiderstand R mit Masse verbunden. Die Basis von LT ist über eine Parallelschaltung aus einem Widerstand RS und einem Kondensator CS mit dem Steuerausgang SA einer monolithisch integrierten Ansteuerschaltung AS verbunden. Der Verbindungspunkt zwischen dem Emitter von LT und R ist mit dem Istwerteingang IE der Ansteuerschaltung AS verbunden.

Innerhalb der Ansteuerschaltung AS befindet sich ein Differenzverstärker DV, der in herkömmlicher Weise einen linken Eingangstransistor TL und einen rechten Eingangstransistor TR aufweist, deren Emitter je an eine Stromquelle SL bzw. SR angeschlossen und außerdem über einen Verbindungswiderstand RV miteinander verbunden sind. Zwischen einem linken Ausgangsanschluß AL und einem rechten Ausgangsanschluß AR des Differenzverstärkers DV entsteht eine Spannung, die von der Potentialdifferenz zwischen einem linken Eingang L und einem rechten Eingang R des Differenzverstärkers DV abhängt. Mit Hilfe einer Spannung-Strom-Wandlerschaltung wird am Steuerausgang SA der Ansteuerschaltung AS ein Strom erzeugt, der der Spannung zwischen AL und AR proportional ist. Die Spannung-Strom-Wandlerschaltung umfaßt zwei Widerstände RL und RR, die einen Endes an die Ausgänge AL bzw. AR des Differenzverstärkers DV angeschlossen und anderen Endes gemeinsam mit dem Emitter eines Transistors T1 verbunden sind. Der Kollektor von T1 ist mit einer Versorgungsspannungsquelle U2 verbunden. Die Ausgänge AL und AR sind außerdem an den nichtinvertierenden Eingang eines Operationsverstärkers V1 bzw. an den invertierenden Eingang eines Operationsverstärkers V2 angeschlossen. Der Ausgang von V2 ist an die Basis von T1 angeschlossen und der Ausgang von V1 ist mit den Basisanschlüssen zweier weiterer Transistoren T2 und T3 verbunden. T2 und T3 bilden mit ihren Kollektor-Emitter-Strecken eine Reihenschaltung, die zwischen die Versorgungsspannungsquelle U2 und Masse geschaltet ist. Der Verbindungspunkt zwischen dem Emitter von T2 und dem Kollektor von T3 ist an das eine Ende eines Strom-Spannung-Wandlerwiderstands RW angeschlossen, dessen anderes Ende einerseits mit dem Steuerausgang SA der Ansteuerschaltung AS und andererseits mit dem nichtinvertierenden Eingang von V2 verbunden ist. Das mit den Transistoren T2 und T3 verbundene Ende von RW ist außerdem mit dem invertierenden Eingang von V1 verbunden.

Der von dem gemeinsamen Ausgangsanschluß der Transistoren T2 und T3 an den Ausgangsanschluß SA gelieferte Strom wird mit Hilfe des Widerstands RW in eine entsprechende Spannung umgewandelt, die mit Hilfe der Operationsverstärker V1 und V2 auf einen Spannungswert geregelt wird, welcher der Spannung zwischen den Ausgangsanschlüssen AL und AR des Differenzverstärkers DV entspricht. Auf diese Weise erscheint am Ausgangsanschluß SA und somit an der Basis des Leistungstransistors LT ein Strom, der von der Potentialdifferenz zwischen den Eingängen L und R des Differenzverstärkers DV und von dessen Arbeitskennlinie abhängt. Diese Arbeitskennlinie bestimmt die Transkonduktanzkennlinie der mit dem Differenzverstärker und der Spannung-Strom-Wandlerschaltung aufgebauten Transkonduktanzstufe. Diese Arbeitskennlinie wird so gewählt, daß der Leistungstransistor LT bei jedem ihm während der Dauer des Einschaltimpulses abverlangten Kollektorstrom in dem vorgegebenen Maß übersteuert wird. Entscheidet man sich für ein nichtlineares Transkonduktanzverhalten, d. h., für eine β-inverse oder angenähert β-inverse Arbeitskennlinie des Differenzverstärkers DV, so kann man diese dadurch realisieren, daß man zu der in Fig. 4 dargestellten Differenzstufe mit den beiden Transistoren TL und TR weitere Differenzstufen parallelschaltet, die unterschiedlich vorgespannt sind und dadurch auf unterschiedliche Eingangspotentiale ansprechen.

Der rechte Eingang R des Differenzverstärkers DV ist an den Emitter eines rechten Vortransistors VTR angeschlossen, dessen Kollektor mit Masse und dessen Basis über einen Zwischenwiderstand RZ und den Istwerteingang IE mit dem Verbindungspunkt zwischen dem Sensorwiderstand R und dem Emitter des Leistungstransistors LT verbunden ist. Der linke Eingang L des Differenzverstärkers DV ist an den Emitter eines linken Vortransistors VTL angeschlossen, dessen Kollektor direkt und dessen Basis über einen externen Kondensator C mit Masse verbunden ist. Die Emitter von VTR und VTL sind außerdem je über eine Stromquelle S an die Versorgungsspannungsquelle U2 angeschlossen. Der Kondensator C ist innerhalb der integrierten Ansteuerschaltung AS mit einem Überbrückungstransistor UT überbrückbar, dessen Emitter mit Masse verbunden ist und dessen Kollektor einerseits an den Kondensator C und die Basis von VTL und andererseits an eine steuerbare Stromquelle LS angeschlossen ist, die wiederum mit U2 verbunden ist. Die steuerbare Stromquelle LS wird über einen dritten Verstärker V3 von der über dem Sensorwiderstand R abgegriffenen Istwertspannung gesteuert und liefert einen dieser Istwertspannung proportionalen Strom. Die Basis der Überbrückungstransistors UT ist an den Ausgang einer ODER-Schaltung O angeschlossen, deren beide Eingänge mit einem Steuereingang SE, dem die Einschaltimpulse zugeführt werden, bzw. mit einem Fernsteuereingang FE verbunden sind.

Zwischen dem Steueranschluß SA und der Basis des Leistungstransistors LT befindet sich die Parallelschaltung aus einem Widerstand RS und einem Kondensator CS, die während der Zeitintervalle, in denen der Abschaltbasisstrom des Leistungstransistors LT zur Entladung von dessen Basis negativ wird, als negative Konstantspannungsquelle wirkt.

Der bisher beschriebene Teil der Ansteuerschaltung AS arbeitet folgendermaßen :

Beim Beginn eines dem Steuereingang SE zugeführten Einschaltimpulses wird der Überbrückungstransistor UT leitendgeschaltet, so daß er den externen Kondensator C kurzschließt und der linke Eingang L des Differenzverstärkers DV praktisch auf Massepotential gebracht und während der ganzen Dauer des Einschaltpulses auf Massepotential gehalten wird. Der rechte Eingang R des Differenzverstärkers DV wird dagegen vom Spannungsabfall am Sensorwiderstand R angesteuert. Ein intern erzeugtes Ruhepotential am rechten Eingang R sorgt für einen Ausgangsgrundstrom, der den Start der Mitkopplung in der Regelschleife des Schaltungsgebildes sicherstellt und Offsetfehler kompensiert. Mit ansteigendem Kollektorstrom IC des Leistungstransistors LT steigt auch der Spannungsabfall über R und damit die Ausgangsspannung zwischen den Ausgangsanschlüssen AL und AR des Differenzverstärkers DV und entsprechend der vom Steuerausgang SA an die Basis von LT gelieferte Einschaltbasisstrom, und zwar entsprechend der Arbeitskennlinie des Differenzverstärkers DV. Während der Kollektorstrom IC des Leistungstransistors LT aufgrund der an dessen Kollektor angeschlossenen Schaltung in der in Fig. 2a gezeigten Weise rampenförmig ansteigt, wird wegen des entsprechend ansteigenden Potentials am rechten Eingang R des Differenzverstärkers DV ein durch die Form von dessen Arbeitskennlinie bestimmter Einschaltbasisstrom an den Leistungstransistor LT gegeben, der bei β-inverser Arbeitskennlinie des Differenzverstärkers DV den in Fig. 2c gezeigten Basisstromverlauf IB2 zeigt.

Bei Beendigung des Einschaltimpulses wird der Überbrückungstransistor UT gesperrt, so daß der externe Kondensator C mit dem von der steuerbaren Stromquelle LS gelieferten Ladestrom aufgeladen werden kann. Dieser Aufladestrom ist proportional zu dem zu diesem Zeitpunkt am Sensorwiderstand R auftretenden Spannungsabfall, also proportional zum Wert des bei Beendigung des Einschaltimpulses fließenden Kollektorstroms IC des Leistungstransistors LT. Die Ladespannung über dem Kondensator C steigt also um so stärker an, je höher der Endwert des Kollektorstroms IC bei Beendigung des Einschaltimpulses ist.

Ab Beendigung des Einschaltimpulses wird daher das Potential am linken Eingang L des Differenzverstärkers DV von der Ladespannung über dem Kondensator C bestimmt. Während das Potential am rechten Eingang R des Differenzverstärkers DV quasi-konstant bleibt, weil sich der Kollektorstrom IC des Leistungstransistors LT während der Abschaltverzögerung zwischen den Zeitpunkten tA und tS (Fig. 2a) relativ gesehen nicht mehr wesentlich ändert, steigt das Potential am linken Eingang L des Differenzverstärkers DV rasch an. Die Potentialdifferenz zwischen den Eingangspotentialen des Differenzverstärkers DV nimmt somit rasch ab, was zu einer entsprechenden Abnahme der Ausgangsspannung zwischen AL und AR und somit zu einer entsprechenden Abnahme des in die Basis von LT gelieferten Abschaltbasisstroms führt. Wenn das rasch ansteigende Potential am linken Eingang L das quasi-konstante Potential am rechten Eingang R erreicht hat, wird der Abschaltbasisstrom zu Null. Während des weitergehenden Anstiegs des Potentials am linken Eingang L tritt dann zwischen den Ausgangsanschlüssen AL und AR eine in entgegengesetzter Richtung rasch ansteigende Spannung auf, die einen entsprechenden negativen Basisstrom des Leistungstransistors LT zur Folge hat. Dieser negative Basisstrom entlädt die übersteuerte Basis des Leistungstransistors LT, bis dieser schließlich zum Zeitpunkt tS in den Sperrzustand übergeht, wodurch der Kollektorstrom IC auf Null zurückgeht.

Würde man die erfindungsgemäße Maßnahme, den Aufladestrom für den Kondensator C proportional zum Kollektorstrom IC des Leistungstransistors LT zu steuern, keinen Gebrauch machen, sondern den Kondensator C mit einem von Kollektorstrom IC unabhängigen Strom aufladen, so daß man wie bei den bekannten Ansteuerschaltungen zu einer festliegenden Abfallsteilheit des Abschaltbasisstroms kommt, würde die Abschaltverzögerung des Leistungstransistors LT mit steigendem Endwert seines Kollektorstroms IC zunehmen. Damit würde sich die neue Ansteuerschaltung umgekehrt wie die herkömmlichen Ansteuerschaltungen verhalten, deren Abschaltverzögerung mit zunehmendem Endwert des Kollektorstroms IC kürzer wird. Die neue Ansteuerschaltung wäre daher bei konstanter Abfallsteilheit des Basisabschaltstroms mit der für die herkömmlichen Ansteuerschaltungen konzipierten φ2-Regelschaltung nicht mehr verwendbar. Dieser Regelkreis würde ein quasi-stabiles Verhalten zeigen, bei dem auf ein Ablenksignal des Leistungstransistors mit maximaler Einschaltdauer und maximalem Kollektorspitzenstrom ein solches mit minimalem Strom und minimaler Dauer folgen würde.

Dieses bei Verwendung der herkömmlichen φ2-Regelschaltung störende, jedoch physikalisch « normale » Verhalten des Leistungstransistors, bei größerem Kollektorstrom auch eine größere Speicherzeit zu zeigen, wird durch die erfindungsgemäße Maßnahme, die Steilheit der Abfallflanke des Basisentladestroms proportional zum Spitzenstrom des Leistungstransistors zu steuern, überwunden. Durch die erfindungsgemäße Maßnahme, die Steilheit des Basisabschaltstroms proportional zum Kollektorspitzenstrom und damit die bis zur Entladung der übersteuerten Basis erforderliche Zeit, d. h., die Speicherverzögerungszeit, umgekehrt proportional zum Kollektorspitzenstrom zu machen, wird in dieser Hinsicht ein gleiches Verhalten wie bei den bekannten Horizontalablenkschaltungen erreicht, so

7

daß ein stabiler Betrieb der φ2-Regelschaltung mit der erfindungsgemäßen Ansteuerschaltung ermöglicht ist.

Im Vergleich zu den herkömmlichen Ansteuerschaltungen führt die erfindungsgemäße Ansteuerschaltung außerdem zu einer deutlich kürzeren Einschwingdauer vom Einschalten bis zum stationären Betrieb. Zusätzlich wird die Sättigung des Leistungstransistors bereits in dieser Phase gewährleistet. Die herkömmlichen Lösungen benötigen eine vielfach längere Einschwingdauer, ohne daß der Leistungstransistor hierbei gesättigt wird. Es treten daher besonders große Verlustleistungen auf, welche die Zuverlässigkeit und Lebensdauer des Leistungstransistors beeinflussen können. Diese Probleme sind also mit der erfindungsgemäßen Ansteuerschaltung ebenfalls überwunden worden.

Die in Fig. 4 dargestellte, besonders bevorzugte Ausführungsform der Erfindung weist folgende zusätzliche Merkmale auf.

Zum Schutz vor zu hoher Strombelastung des Leistungstransistors LT ist eine Strombegrenzungsschaltung in Form eines Transistors T5 vorgesehen, dessen Kollektor an den Emitter des rechten Vortransistors VTR und dessen Emitter an eine Referenzspannungsquelle $U_{ref}$ angeschlossen ist. Die Basis von T5 ist über eine Diode D5 an den Istspannungseingang IE und über eine Stromquelle S5 an die Versorgungsspannungsquelle U2 angeschlossen. Wenn der Kollektorstrom IC des Leistungstransistors LT und damit der Spannungsabfall über dem Sensorwiderstand R einen bestimmten, von $U_{ref}$ abhängenden Wert übersteigt, wird T5 leitend und begrenzt das Potential am rechten Eingang R des Differenzverstärkers DV auf einen von $U_{ref}$ abhängenden Potentialwert. Dadurch wird der an die Basis des Leistungstransistors LT gelieferte Strom entsprechend begrenzt, was aufgrund der endlichen Stromverstärkung β des Leistungstransistors zu einer Begrenzung von dessen Kollektorstrom führt.

Eine Klammerschaltung mit einem Transistor T6, dessen Emitter an den Istwerteingang IE, dessen Kollektor an die Versorgungsspannungsquelle U2 und dessen Basis über eine Diode D6 einerseits an Masse und über eine Stromquelle S6 andererseits an U2 angeschlossen sind, verhindert, daß das Potential am rechten Eingang R des Differenzverstärkers DV negative Werte annimmt. Dies könnte ohne diese Schutzmaßnahme bei Leistungstransistoren mit integrierter Freilaufdiode passieren, da sich in der Diodenleitphase der Spannungsabfall am Sensorwiderstand R umkehrt.

Während des Zeilenrücklaufsignals treten am Leistungstransistor LT hohe Spannungswerte auf. Würde während dieser Phase der Leistungstransistor LT eingeschaltet und in ihm ein Strom fließen, entstünden sehr hohe Verlustleistungen, die ihn zerstören könnten. Um dies zu verhindern, ist ein Transistor T4 vorgesehen, dessen Kollektor an den gemeinsamen Basisanschluß der beiden Transistoren T2 und T3 angeschlossen ist und dessen Emitter mit Masse verbunden ist. Die Basis des Transistors T4 ist an einen Einschalteingang EE der Ansteuerschaltung AS angeschlossen, über den der Transistor T4 während des Vorhandenseins des Zeilenrücklaufsignals leitend geschaltet wird, was zum Ausschalten der Transistoren T2 und T3 führt. Dadurch wird der Leistungstransistor LT während des Vorhandenseins der Zeilenrücklaufspannung sicher im Ausschaltzustand gehalten.

An den Fernsteuereingang FE der Ansteuerschaltung AS ist die Basis eines Transistors T7 angeschlossen, dessen Emitter mit Masse und dessen Kollektor über einen Widerstand R7 an die Basis des rechten Vortransistors VTR angeschlossen ist. Die Basis von VTR ist außerdem über eine weitere Stromquelle S7 an die Versorgungsspannungsquelle U2 angeschlossen. Wird der Fernsehempfänger z. B. mittels einer Fernsteuerung in den sogenannten Stand-by-Zustand geschaltet, gelangt an den Fernsteuereingang FE ein Einschaltsignal, das über die ODER-Schaltung O den Überbrückungstransistor UT und auf direktem Wege den Transistor 7 leitend schaltet. Dadurch gelangt der linke Eingang L des Differenzverstärkers DV praktisch auf Massepotential und der rechte Eingang R auf ein vom Widerstand R7 und dem Strom von der Stromquelle S7 abhängendes Potential, das zur Ansteuerung des Leistungstransistors LT mit einem konstanten Basisstrom führt.

Bei der dargestellten Ausführungsform sind sämtliche Transistoren als NPN-Transistoren ausgebildet. Bei monolithischer Integration der Ansteuerschaltung AS werden diese gegenüber PNP-Transistoren vorgezogen, und zwar wegen der niedrigeren Grenzfrequenz monolithisch integrierter PNP-Transistoren. Aus dem gleichen Grund ist auch die dem Differenzverstärker DV nachgeschaltete Spannung-Strom-Wandlerschaltung mit zwei Verstärkern realisiert, nämlich um langsame PNP-Stufen zu vermeiden.

**Patentansprüche**

1. Ansteuerschaltung für einen Leistungstransistor, der sich in einer Ablenkschaltung eines Fernsehgeräts befindet und eine Ablenkwicklung mit einem rampenförmig ansteigenden Ablenkstrom versorgt, wobei die Ansteuerschaltung
— periodisch mit Einschaltimpulsen einer der Rampenlänge des Ablenkstroms entsprechenden Dauer gespeist wird,
— den Leistungstransistor während der Einschaltimpulsdauer mit einem ansteigenden Einschaltbasisstrom beaufschlagt, der den Leistungstransistor während im wesentlichen der gesamten Einschaltimpulsdauer in den Sättigungszustand steuert,
— und nach Beendigung des Einschaltimpulses den Leistungstransistor mit einem im Verhältnis zum Anstieg des Einschaltbasisstroms rasch abnehmenden und schließlich die Polarität wechselnden Abschaltbasisstrom steuert, der eine schnelle Rückführung des Leistungstransistors aus dem Sättigungs-in den Sperrzustand bewirkt,

dadurch gekennzeichnet,

— daß dem Leistungstransistor (LT) eine Sensorvorrichtung (R) zugeordnet ist, die der Ansteuerschaltung (AS) ein dem Momentanwert des Transistorhauptstroms proportionales Istwertsignal liefert,

— daß die Ansteuerschaltung (AS) den Einschaltbasisstrom während seines gesamten Anstiegs in Abhängigkeit von dem Istwertsignal auf einen Wert regelt, der den Leistungstransistor (LT) mit nur geringer Übersteuerung in dem gesättigten Zustand hält,

— und daß die Ansteuerschaltung (AS) die Steilheit des Abschaltbasisstroms proportional zu dem am Ende des Einschaltimpulses auftretenden Istwertsignal steuert.

2. Ansteuerschaltung nach Anspruch 1, dadurch gekennzeichnet, daß die Sensorvorrichtung durch einen Emitterwiderstand (R) des Leistungstransistors (LT) gebildet ist, über dem eine zum Kollektorstrom (IC) des Leistungstransistors (LT) proportionale Istwertspannung abgreifbar ist, und daß die Ansteuerschaltung eine Transkonduktanzstufe (TK) mit einem Istwerteingang (IE) und einem mit der Basis des Leistungstransistors (LT) verbundenen Steuerausgang (SA) aufweist, wobei deren Transkonduktanzkennlinie derart gewählt ist, daß die Transkonduktanzstufe (TK) bei jeder ihr zugeführten Istwertspannung an den Leistungstransistor (LT) einen Einschaltbasisstrom liefert, der eine Sättigung des Leistungstransistors (LT) bei nur geringer Übersteuerung bewirkt.

3. Ansteuerschaltung nach Anspruch 2, dadurch gekennzeichnet, daß die Transkonduktanzstufe (TK) eine lineare Transkonduktanzkennline aufweist.

4. Ansteuerschaltung nach Anspruoh 2, dadurch gekennzeichnet, daß die Transkonduktanzstufe (TK) eine nichtlineare Transkonduktanzkennlinie aufweist, deren Verlauf eine wenigstens angenäherte inverse Nachbildung des Kennlinienverlaufs der Stromverstärkung ($\beta$) des Leistungstransistors (LT) in Abhängigkeit von dessen Kollektorstrom (IC) ist.

5. Ansteuerschaltung nach einem der Ansprüche 2 bis 4, dadurch gekennzeichnet, daß die Transkonduktanzstufe eine spannungsgesteuerte Stromquelle aufweist, die durch die Istwertspannung steuerbar ist.

6. Ansteuerschaltung nach einem der Ansprüche 2 bis 5, dadurch gekennzeichnet, daß die Transkonduktanzstufe (TK) in Abhängigkeit von dem Vorhandensein oder Nichtvorhandensein des Einschaltimpulses in einen ersten Zustand, in dem sie zur Steuerung des ansteigenden Basiseinschaltstroms nur auf die ihr zugeführte Istwertspannung reagiert, bzw. in einen zweiten Zustand, in dem sie zur Steuerung des abfallenden Basisausschaltstroms auf das Verhältnis zwischen der Istwertspannung und einer sich entgegengesetzt wie die Istwertspannung auswirkenden, rasch ansteigenden Steuerspannung reagiert, steuerbar ist, und daß die Steilheit der im zweiten Zustand wirkenden Steuerspannung proportional zur Istwertspannung veränderbar ist.

7. Ansteuerschaltung nach Anspruch 6, dadurch gekennzeichnet, daß die Transkonduktanzstufe (TK) einen Differenzverstärker (DV) aufweist und eine dessen Ausgang nachgeschaltete Spannung-Strom-Wandlerschaltung (T1, T2, T3, V1, V2, RL, RR, RW), deren Ausgang den Steuerausgang (SA) der Transkonduktanzstufe bildet, daß der eine (R) der beiden Eingänge des Differenzverstärkers (DV) mit dem Istwerteingang (IE) der Ansteuerschaltung (AS) verbunden ist, daß der andere Eingang (L) des Differenzverstärkers (DV) an eine Parallelschaltung aus einem Kondensator (C) und der Hauptstrecke eines Überbrückungstransistors (UT) angeschlossen ist, wobei die Parallelschaltung einen Endes an ein Bezugspotential, vorzugsweise Masse, und anderen Endes an eine steuerbare Stromquelle (LS), deren Stromstärke proportional zur Istwertspannung steuerbar ist, angeschlossen ist, und daß die Steuerelektrode des Überbrückungstransistors (UT) an den Einschaltimpulseingang (SE) der Ansteuerschaltung (AS) angeschlossen ist und der Überbrückungstransistor (UT) durch den Einschaltimpuls leitend schaltbar ist und ansonsten sperrt.

## Claims

1. A driving circuit for a power transistor which is provided in a deflectional system of a television set and supplies a deflecting current increasing in ramp-shaped manner to a deflection coil, the driving circuit

— being periodically fed with switching-on pulses of a duration corresponding to the ramp length of the deflecting current,

— applying an increasing switched-on base current to the power transistor during the switching-on pulse duration, said switched-on base current driving the power transistor into the saturation state during substantially the entire switching-on pulse duration,

— and after termination of the switching-on pulse, controlling the power transistor with a switching-off base current which rapidly decreases in relation to the increase of the switched-on base current and finally changes polarity and which effects a rapid return of the power transistor from the saturation state into the blocking state, characterized in

— that the power transistor (LT) has a sensor means (R) associated therewith which supplies to the

9

driving circuit (AS) an actual-value signal which is proportional to the instantaneous value of the transistor main current,

— that the driving circuit (AS) regulates the switched-on base current, during the entire increase thereof and in accordance with said actual-value signal, to a value which maintains the power transistor (LT) in the saturated state with only a slight degree of saturation,

— and that the driving circuit (AS) controls the steepness of the switching-off base current proportionally to the actual-value signal occurring at the end of the switching-on pulse.

2. A driving circuit according to claim 1, characterized in that said sensor means is formed by an emitter resistor (R) of the power transistor (LT), across which an actual-value voltage is available which is proportional to the collector current (IC) of the power transistor (LT), and that said driving circuit comprises a transconductance stage (TK) having an actual-value input (IE) and a control output (SA) which is coupled to the base of said power transistor (LT), the transconductance characteristic of said transconductance stage (TK) being selected such that said transconductance stage (TK), in case of each actual-value voltage supplied thereto, supplies to said power transistor (LT) a switched-on base current which effects a saturation of said power transistor (LT) with only a slight degree of saturation.

3. A driving circuit according to claim 2, characterized in that said transconductance state (TK) has a linear transconductance characteristic.

4. A driving circuit according to claim 2, characterized in that said transconductance state (TK) has a non-linear transconductance characteristic which is an at least approximated inverse copy of the characteristic of the power transistor current gain ($\beta$) versus the collector current (IC) thereof.

5. A driving circuit according to any one of the claims 2 to 4, characterized in that said transconductance stage comprises a voltage-controlled current source which is controllable by said actual-value voltage.

6. A driving circuit according to any one of the claims 2 to 5, characterized in that said transconductance stage (TK), in response to the fact whether the switching-on pulse is present or not, is adapted to be driven into a first state in which it reacts only to the actual-value voltage supplied thereto, in order to control the increasing switched-on base current, and respectively, into a second state in which it reacts to the ratio between said actual-value voltage and a rapidly increasing control voltage having an effect opposite to that of said actual-value voltage, in order to control the decreasing switching-off base current, and that the steepness of the control voltage effective in said second state is adapted to be changed proportionally to said actual-value voltage.

7. A driving circuit according to claim 6, characterized in that said transconductance stage (TK) comprises a differential amplifier (DV) and a voltage-current converter circuit (T1, T2, T3, V1, V2, RL, RR, RW) which is disposed subsequent to the output of said differential amplifier (DV) and the output of which forms the control output (SA) of said transconductance state, that the one (R) of the two inputs of said differential amplifier (DV) is coupled to the actual-value input (IE) of the driving circuit (AS), that the other input (L) of said differential amplifier (DV) is connected to a parallel connection consisting of a capacitor (C) and of the main path of a shunting transistor (UT), said parallel connection being connected at one end to a reference potential, preferably ground, and at the other end to a controllable current source (LS) whose current intensity is controllable proportionally to the actual-value voltage, and that the control electrode of said shunting transistor (UT) is connected to the switching-on pulse input (SE) of the driving circuit (AS) and the shunting transistor (UT) is adapted to be switched into the conductive state by the switching-on pulse and otherwise blocks.

**Revendications**

1. Circuit d'attaque pour un transistor de puissance qui se trouve dans un circuit de déviation d'un appareil de télévision et alimente un bobinage de déviation à courant de déviation montant en forme de rampe, le circuit d'attaque :

— étant alimenté par des impulsions d'enclenchement d'une durée correspondant à la longueur de rampe du courant de déviation,

— sollicitant le transistor de puissance pendant la durée de l'impulsion d'enclenchement, avec un courant de base d'enclenchement croissant, qui commande le transistor de puissance pendant pratiquement la totalité de la durée d'impulsion d'enclenchement, à l'état de saturation,

— et, après achèvement de l'impulsion d'enclenchement, commande le transistor de puissance, avec un courant de base de déclenchement décroissant rapidement en comparaison de l'accroissement du courant de base d'enclenchement et inversant finalement la polarité, courant qui provoque un rappel rapide du transistor de puissance en quittant l'état de saturation pour passer en état de blocage, caractérisé en ce que

— un dispositif de capteur (R) délivrant au circuit d'attaque (AS) un signal de valeur réelle proportionnel à la valeur instantanée du courant principal du transistor est associé au transistor de puissance (LT),

— le circuit d'attaque (AS) règle le courant de base de déclenchement pendant la totalité de sa montée en fonction du signal de valeur réelle, à une valeur maintenant à l'état saturé le transistor de puissance (LT) avec une surcharge seulement faible,

— le circuit d'attaque (AS) commande la pente du courant de base de déclenchement, proportionnellement au signal de valeur réelle survenant à la fin de l'impulsion d'enclenchement.

2. Circuit d'attaque, selon la revendication 1, caractérisé en ce que le dispositif à capteur est formé par une résistance d'émetteur (R) du transistor de puissance (LT), par l'intermédiaire duquel on peut capter une tension de valeur réelle proportionnelle au courant de collecteur (IC) du transistor de puissance (LT), et en ce que le circuit d'attaque présente un étage de transconductance (TK) avec une entrée de valeur réelle (IE) et une sortie de commande (SA) reliée à la base du transistor de puissance (IE), sa caractéristique de transconductance étant choisie de façon que l'étage de transconductance (TK) délivre au transistor de puissance (LT), pour chaque tension de valeurs réelle qui lui est fournie, un courant de base d'enclenchement provoquant une saturation du transistor de puissance (LT) pour une surcharge seulement faible.

3. Circuit d'attaque, selon la revendication 2, caractérisé en ce que l'étage de transconductance (TK) présente une caractéristique de transconductance linéaire.

4. Circuit d'attaque, selon la revendication 2, caractérisé en ce que l'étage de transconductance (TK) présente une caractéristique de transconductance non linéaire, dont l'allure est une reproduction inverse au moins approchée de l'allure de caractéristique de l'amplification en courant ($\beta$) du transistor de puissance (LT) en fonction de son courant de collecteur (IC).

5. Circuit d'attaque, selon l'une des revendications 2 à 4, caractérisé en ce que l'étage de transconductance présente une source de courant commandée en tension, qui est commandable par la valeur réelle de la tension.

6. Circuit d'attaque, selon l'une des revendications 2 à 5, caractérisé en ce que l'étage de transconductance (TK) qui est commandable en fonction de la présence ou en l'absence de l'impulsion d'enclenchement, en un premier état dans lequel il réagit uniquement à la valeur réelle de la tension qui lui est amenée, en vue d'une commande du courant d'enclenchement de base croissant, ou en un deuxième état dans lequel il réagit au rapport existant entre la tension réelle et une tension de commande croissant rapidement, agissant en sens opposé à la tension réelle, en vue d'une commande du courant de déclenchement de base diminuant, et en ce que la pente de la tension de commande agissant dans le deuxième état est modifiable proportionnellement à la tension réelle.

7. Circuit d'attaque, selon la revendication 6, caractérisé en ce que l'étage de transductance (TK) présente un amplificateur différentiel (DV) et un circuit aval de convertisseur tension-courant (T1, T2, T3, V1, V2, RL, RR, RW), dont la sortie constitue la sortie de commande (SA) de l'étage de transconductance, en ce qu'une des deux entrées de l'amplificateur différentiel (DV) est reliée à l'entrée de valeur réelle (IE) du circuit d'attaque (AS), en ce que l'autre entrée (L) de l'amplificateur différentiel (DV) est raccordé à un circuit parallèle se composant d'un condensateur (C) et de la voie principale d'un transistor de pontage (UT), le circuit parallèle étant raccordé à une extrémité à un potentiel de référence, de préférence à la masse, et à l'autre extrémité à une source de courant (LS) commandable, dont l'intensité est proportionnelle à la valeur réelle de la tension, et en ce que l'électrode de commande du transistor de pontage (UT) est raccordée à l'entrée d'impulsion d'enclenchement (SE) du circuit d'attaque (AS) et le transistor de pontage (UT) connectant de manière passante lors de l'impulsion d'enclenchement et étant autrement bloquant.

FIG.1A

FIG.1B

FIG.1C

FIG.2A

FIG.2B

FIG.2C

FIG. 3

FIG. 4

EP 0 163 302 B1